# EUROPÄISCHE PATENTSCHRIFT

(11) **EP 3 555 705 B1**
(45) Veröffentlichungstag und Bekanntmachung des Hinweises auf die Patenterteilung: **07.06.2023**
(21) Anmeldenummer: 17808075.0
(22) Anmeldetag: 01.12.2017
(51) Int. Cl.: G03F 7/00

(54) **VORRICHTUNG SOWIE EIN VERFAHREN ZUR HERSTELLUNG GROSSFLÄCHIGER PERIODISCHER NANOSTRUKTUREN AUF EINEM FLÄCHENHAFT AUSGEDEHNTEN SUBSTRAT MITTELS EINES NANOIMPRINTVERFAHRENS**
DEVICE AND METHOD FOR PRODUCING LARGE-AREA PERIODIC NANOSTRUCTURES ON AN EXTENSIVE SUBSTRATE BY MEANS OF A NANOIMPRINT METHOD
DISPOSITIF ET PROCÉDÉ DE RÉALISATION DE NANOSTRUCTURES PÉRIODIQUES DE GRANDE SURFACE SUR UN SUBSTRAT PLANAIRE AU MOYEN D'UN PROCÉDÉ DE NANO-IMPRESSION

(30) Priorität: 14.12.2016 DE 102016124428
(43) Veröffentlichungstag der Anmeldung: 23.10.2019
(73) Patentinhaber: AMO GmbH, 52074 Aachen (DE)
(72) Erfinder: BOLTEN, Jens, 52064 Aachen (DE); SCHLACHTER, Florian, 52511 Geilenkirchen (DE)
(74) Vertreter: Patentanwälte Bauer Vorberg Kayser
(86) Internationale Anmeldenummer: PCT/EP2017/081192
(87) Internationale Veröffentlichungsnummer: WO 2018/108579

(56) Entgegenhaltungen:
- EP-A2- 1 972 997
- EP-A2- 2 942 667
- WO-A1-2013/083184
- US-A1- 2009 273 124
- US-A1- 2011 064 838
- US-A1- 2015 266 234
- JUN-HYUK CHOI ET AL: "Large-Area Nanotemplate Process and Its Application to Roll Imprint", JAPANESE JOURNAL OF APPLIED PHYSICS, Bd. 51, 1. Juni 2012 (2012-06-01), Seite 06FJ01, XP055452650, JP ISSN: 0021-4922, DOI: 10.1143/JJAP.51.06FJ01
- YANG SEN-YEU ET AL: "Fabrication of microlens arrays using UV micro-stamping with soft roller and gas-pressurized platform", MICROELECTRONIC ENGINEERING, Bd. 85, Nr. 3, 22. November 2007 (2007-11-22), Seiten 603-609, XP029225482, ISSN: 0167-9317, DOI: 10.1016/J.MEE.2007.11.004

## Beschreibung

Gegenstand der vorliegenden Erfindung ist eine Vorrichtung sowie ein Verfahren zur Herstellung großflächiger periodischer Nanostrukturen auf einem flächenhaft ausgedehnten Substrat mittels eines Nanoimprintverfahrens.

Die dieser Anmeldung zu Grunde liegende Erfindung wurde gemacht im Rahmen eines Forschungsprojekts, welches durch Mittel aus dem Programm der Europäischen Union für Forschung und Innovation "Horizont 2020" unter der Vergabenummer 646130 gefördert wurde.

Die Forderung, Strukturen im Nano- oder Mikrobereich schnell, ökonomisch und reproduzierbar herzustellen, ist eine der Hauptmotivationen bei der Entwicklung der Nanotechnologie.

Ein kostengünstiges Verfahren ist die sogenannte Nanoimprint, eine Lithographietechnologie zur Fabrikation nanoskaliger Strukturen z.B. im Bereich der Nanoelektronik, Photonik und Biotechnologie. Die grundlegende Idee ist die Replikation von Strukturen, welche in einen Stempel eingebracht, beispielsweise geätzt, wurden, durch das Eindrücken dieser strukturierten Stempeloberfläche in ein aushärtbares, fließfähiges Imprintmaterial mit hoher Viskosität auf einer Substratoberfläche. Das Imprintmaterial ist typisch ein Polymer oder Monomer, bevorzugt ein rein-organisches Monomer oder ein organisches/anorganisches Verbundmonomer. Nach dem Auffüllen aller Hohlräume der strukturierten Stempeloberfläche mit dem Imprintmaterial wird mittels Wärme und/oder UV-Licht das Imprintmaterial ausgehärtet. Im letzten Schritt wird der Stempel entfernt und es verbleibt eine 3-dimensionale Replikation der Struktur in der Imprintmaterialbeschichtung auf dem Substrat.

Aus der EP 2 942 667 A2 ist ein Mustererzeugungsverfahren unter Verwendung einer Aufdruckform zum Formen einer aufgedruckten Musterstruktur bekannt. Es basiert auf dem Bereitstellen einer Lackschicht in Form eines thermoplastischen Polymers, aus dem die aufgedruckte Struktur geformt wird. In einem ersten Aufdruckprozess wird auf einem ersten Bereich der Lackschicht mithilfe der Aufdruckform ein erstes Muster der Musterstruktur durch Deformieren der Lackschicht im ersten Bereich erzeugt. In einem zweiten Aufdruckprozess auf einem zweiten Bereich der Lackschicht wird mithilfe der Aufdruckform ein zweites Muster der Musterstruktur durch Deformieren der Lackschicht im zweiten Bereich erzeugt. Dabei überlappen sich der erste und der zweite Bereich der Lackschicht in einem dritten Bereich. Dabei umfasst die Aufdruckform eine Trägerplatte mit der Form einer flachen Platte und einen weichen Stempel, der an der Trägerplatte angebracht ist.

Aus der US 5,425,848 A ist ein walzenförmiger Stempel mit strukturierter Walzenoberfläche bekannt, der auf dem mit einer Beschichtung aus einem Imprintmaterial versehenen Substrat abrollt, um die Beschichtung zu prägen. Die geprägte Imprintmaterialbeschichtung wird durch eine UV-Bestrahlung im Bereich des Walzenspaltes unmittelbar ausgehärtet. Mittels dieser Technik lassen sich insbesondere periodische Strukturen hoher Qualität auf dem Substrat erzeugen.

Durch Weiterverarbeitung kann die Nanostruktur der strukturierten Imprintmaterialbeschichtung dann in das darunterliegende Substrat übertragen werden, z.B. mittels Ätzen. Ein entsprechendes Verfahren wird beispielsweise in der US 2007/059497 A1 beschrieben.

Ein Imprintstempel weist auf seiner Stempelseite eine dreidimensionale Oberflächenstruktur als Stempelstruktur auf, deren laterale Ausdehnung die Stempelfläche definiert und die mit verschiedenen Verfahren in ein Imprintmaterial übertragen werden kann. Dieses Imprintmaterial muss unabhängig vom Verfahren in der Lage sein, sich beim Eindrücken der Stempelfläche zu verformen und die Struktur der abformfähigen dreidimensionalen Oberflächenstruktur der Stempelfläche nachzubilden. Demnach muss das Stempelmaterial, in dem die dreidimensionale Oberflächenstruktur als Imprintnegativ erzeugt ist, eine gewisse Härte aufweisen, die ausreicht, um die Verformung gegebenenfalls unter Druckausübung im Imprintmaterial hervorzurufen. Weiterhin muss die Stempelstruktur ausreichend fest und widerstandsfähig sein, um ohne Schaden der Oberflächenstruktur der Stempelfläche mehrfach anwendbar zu sein.

Das Verfahren des Übertragens der Oberflächenstruktur des Stempels in ein Imprintmaterial kann je nach Imprintmaterial unterschiedlich erfolgen. Gemein haben die Verfahren stets, dass ein über die Stempelfläche vollständiger und gleichmäßig kräfteverteilter Kontakt zum Imprintmaterial gewünscht ist. Hierbei sind Einschlüsse von Luftblasen zu verhindern, so dass beispielsweise der Kontakt zwischen Stempelfläche und Imprintmaterial unter Vakuum oder unter einem Zustellwinkel oder mittels verformbarer Vorrichtungen mit weichen Materialien wie Silikon erfolgt.

Im einfachsten Fall wird bei entsprechender Härte der Stempelstruktur und entsprechender Verformbarkeit des Imprintmaterials die Stempelstruktur durch den bloßen Druck auf das Imprintmaterial dauerhaft übertragen.

Ein präziseres und schonenderes Verfahren basiert auf flüssigen oder hochviskosen Imprintmaterialien, die in der Phase der Strukturübernahme noch nicht formstabil sind. Die Stempelstruktur ist im Kontakt mit dem Imprintmaterial dann leicht abzubilden, muss aber noch im Imprintmaterial verfestigt werden. Je nach Empfindlichkeit des Imprintmaterials verfestigen sich diese unter Austreibung von Lösungsmitteln, Eintrag von Wärme, Entzug von Wärme oder UV-Strahlung oder in einer Kombination oder in einer Abfolge hieraus. Dies bedeutet, dass in der Regel der Imprintstempel solange mit dem Imprintmaterial in Kontakt stehen und die Abformung aufrecht erhalten werden muss, bis das Imprintmaterial mit geeigneten Mitteln verfestigt wurde. Nach der Verfestigung ist der Vorgang der Entformung der Stempelstruktur von der nun verfestigten Struktur im Imprintmaterial durch die Anhaftungskräfte erschwert. Ein vollflächiges Entformen in Richtung der Oberflächennormalen oder lotrechter Richtung zur Oberfläche ist dabei regelmäßig aufgrund der großen Oberfläche der Stempelstruktur, des luftdichten Kontaktes und der Haftungskräfte vom Material nicht leicht möglich. Vielmehr ist die Entformung erleichtert, wenn die Stempelstruktur unter einem Keilwinkel vom Imprintmaterial abgehoben wird, so dass sich das Entformen an einer Stelle beginnend zeit- bzw. ortsversetzt fortsetzt. Bei starren Stempeln ohne Flexibilität kann dies mit konstantem oder steigendem Keilwinkel erfolgen. Bei hochflexiblen Stempeln ist ein stark lokalisiertes Entformungsverhalten ähnlich dem Abziehen von Aufklebern möglich.

Relevante Anwendungen von Imprintverfahren bestehen im Bereich der Halbleiterfertigung oder Herstellung von optischen Bauelementen, wobei die kleinsten Strukturgrößen einer Stempelstruktur weniger als 1 mm betragen, also im Bereich von Mikrometern liegen, oder weniger als 1µm betragen, also im Bereich von Nanometern liegen. In diesem Fall spricht man von Nanoimprint-Verfahren. Übliche Substratgrößen liegen bei 200mm bis 300mm Durchmesser im Falle von heutigen runden Wafersubstraten.

Die Anwendungen von Nanoimprintverfahren sind aber nicht beschränkt auf spezielle Formate, sondern auch für größere Substratgrößen und beliebige Außengeometrien, beispielsweise für Solarpanels mit Flächen von einigen Quadratmetern zu finden. Für die vorliegende Schrift ist der allgemein gebrauchte Begriff des Imprintverfahrens und des Imprintstempels nicht beschränkt auf eine bestimmte Längendimension, sondern umfasst die Ausführung und Anwendung im Mikrometer- und Nanometerbereich, insbesondere das Nanoimprintverfahren und einen Nanoimprintstempel.

Für derlei Anwendungen im Zusammenhang mit Nanoimprintverfahren und Vorrichtungen zu deren Ausführung ist die Eigenschaft der Verzugsfreiheit fundamental, da eine laterale Dehnung der Stempelstruktur zu Abweichungen der abgeformten Imprintstruktur, der Positionen zueinander und der Abstände führt, die die Funktion des Bauteils oder der Imprintstruktur verhindern. Diese Anforderung steht unter anderem in Konkurrenz zur Forderung nach Materialflexibilität, die erforderlich ist für eine lufteinschlussfreie Zustellung der Stempelstruktur in das Imprintmaterial oder die zeit- und ortsversetzte Entformung mit flexiblen Stempeln.

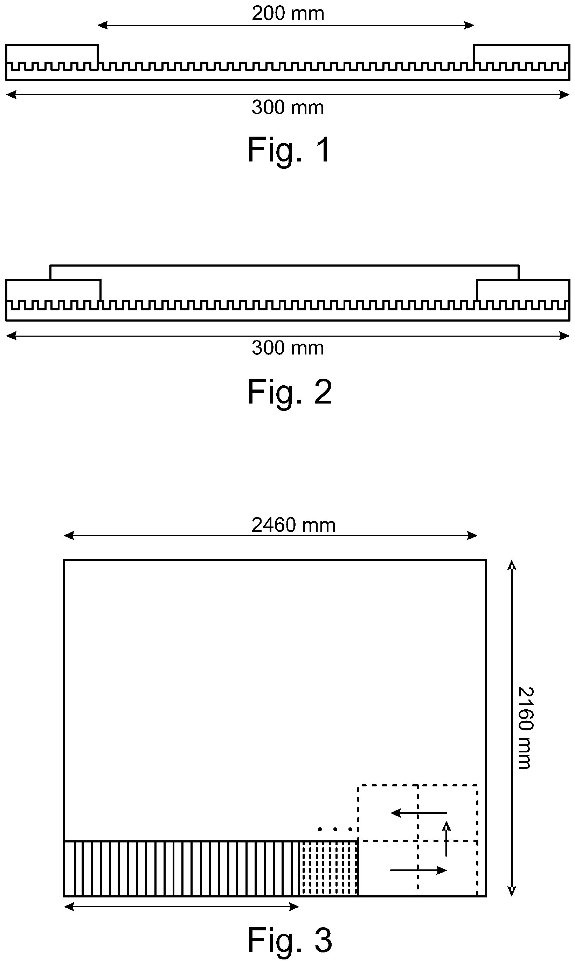

Insbesondere die eingangs genannte "roll-to-plate"-Technik gemäß der US 5,425,848 A des Übertragens einer Struktur von einem strukturierten Stempel, welcher auf einer Walze angeordnet ist, in eine auf ein Substrat aufgebrachte Beschichtung aus einem hochviskosen Imprintmaterial stößt hier an seine Grenzen. Dieses Verfahren ist beispielhaft in Figur 2 dargestellt. So ist es zwar trotz eines sehr hohen technologischen Aufwands grundsätzlich denkbar, einen nanostrukturierten Imprintstempel herzustellen, dessen Erstreckung zumindest in einer Raumrichtung der Erstreckung eines sehr großen Substrats entspricht. Bislang sind aber keine Verfahren bekannt, die es erlauben würden, einen derartigen Stempel, der wie vorstehend erwähnt für die Nanoimprinttechnologie zwingend eine gewisse Flexibilität aufweisen muss, verzerrungsfrei auf der Mantelfläche einer eine Walze anzuordnen. Wegen der i.A. hohen Anforderungen an die Verzugsfreiheit der hergestellten Strukturen in der Imprintmaterialbeschichtung scheidet eine Anwendung dieser Walztechnik auf die (Nano-)Strukturierung großformatiger Substrate o.g. Dimensionen praktisch aus.

In einem alternativen Ansatz, der im Stand der Technik auch mit "step&repeat" bezeichnet wird und der aus Figur 1 ersichtlich ist, wird ein Stempel mit im Vergleich zum Zielsubstrat kleiner Stempelfläche in eine auf diesem aufgebrachte Imprintmaterialbeschichtung abgeformt, Stempel oder Zielsubstrat sodann bewegt und der Stempel erneut in einen anderen Bereich der Imprintmaterialbeschichtung abgeformt. Dieser Vorgang wird solange wiederholt, bis die gesamte Fläche des Zielsubstrats entsprechend bearbeitet wurde und mit einer (Nano-)Struktur versehen ist. Bei diesem Verfahren ergibt sich weniger das Problem einer Verzerrung des Stempels, da dessen Größe verhältnismäßig klein gehalten werden kann. Jedoch ist dieses rein seriell arbeitende Verfahren sehr zeitaufwändig. Darüber hinaus hat es sich in der Praxis als problematisch erwiesen, die in den einzelnen Prägevorgängen erzeugten (Nano-)Strukturen so auf dem Substrat zu positionieren, dass sich diese nahtlos aneinander anfügen oder bevorzugt nahtlos ineinander übergehen. Die erfordert eine relative Positioniergenauigkeit von Stempel und Substrat in zumindest den zwei Dimensionen der Substratoberfläche, die deutlich besser sein muss als die mittlere Strukturgröße des strukturierten Stempels und damit im Bereich von 10 Nanometern und darunter liegen kann.

Die vorliegende Erfindung hat es sich daher zur Aufgabe gemacht, eine Vorrichtung und ein Verfahren zur Herstellung großflächiger periodischer Nanostrukturen auf einem flächenhaft ausgedehnten, Substrat mittels eines Nanoimprintverfahrens anzugeben, welche bzw. welches die Nachteile der aus dem Stand der Technik vorbekannten Vorrichtungen bzw. Verfahren vermeidet.

Gelöst wird diese Aufgabe durch eine Vorrichtung gemäß Anspruch 1 sowie ein Verfahren gemäß Anspruch 10. Vorteilhafte Weiterbildungen der Erfindung sind Gegenstand der Unteransprüche.

Die erfindungsgemäße Vorrichtung ist zur Herstellung großflächiger periodischer Nanostrukturen auf einem flächenhaft ausgedehnten, Substrat mittels eines Nanoimprintverfahrens vorgesehen. Die Vorrichtung weist eine Stempelrolle auf mit einer Längsachse, an deren Umfangsfläche eine Mehrzahl gleichartiger Stempel angeordnet ist. Jeder dieser Stempel bildet in Umfangsrichtung der Stempelrolle eine ringförmige Struktur aus, die bevorzugt nahtlos ist. Weiterhin bildet jeder dieser Stempel eine Nanostruktur aus, die ein Negativ zumindest zu einem Teilbereich der herzustellenden Nanostruktur darstellt.

Der WO 2015/169840 A1 sind umfangreiche Informationen zu entnehmen, die sich auf vorteilhafte (nano-)strukturierte Stempel für Nanoimprintverfahren sowie auf vorteilhafte Verfahren zur Herstellung derartiger Stempel beziehen. Auf die technische Lehre dieser Offenlegungsschrift wird im Zusammenhang mit der vorliegenden Erfindung verwiesen.

Im Kontext der vorliegenden Erfindung sind unter Nanostrukturen auch Strukturen zu verstehen, deren Strukturgrößen im Bereich von Tausenden von Nanometern, also von Mikrometern zu verstehen. Bevorzugt sind unter Nanostrukturen jedoch Strukturen zu verstehen, deren Strukturgrößen zwischen einem und einigen hundert Nanometern, insbesondere zwischen fünf und einhundert Nanometern betragen.

Erfindungsgemäß ist entlang der Längsachse der Stempelrolle an deren Umfangsfläche eine Mehrzahl von gleichartigen Stempeln angeordnet. Dabei sind die Stempel in Richtung der Rollenlängsachse beabstandet voneinander angeordnet, wobei der Abstand der Stempel voneinander kleiner oder gleich der Erstreckung der Stempel in Richtung der Rollenlängsachse ist.

Weiterhin weist die erfindungsgemäße Vorrichtung eine Versatzvorrichtung auf, mittels welcher Stempelrolle und Substrat in Richtung der Rollenlängsachse relativ zueinander um eine definierte Versatzstrecke versetzt werden können.

In einer einfachsten Form des erfindungsgemäßen Verfahrens erlaubt es die erfindungsgemäße Vorrichtung, nach Abwalzen der gesamten Länge des Zielsubstrats mittels der auf der Stempelrolle angeordneten Stempel Substrat oder Stempelrolle um eine Stempelbreite relativ zueinander zu verfahren und das Abwalzen zu wiederholen, und diesen Prozess so lange zu wiederholen, bis gesamte zu strukturierende Fläche des mit einer Schicht aus einem geeigneten Imprintmaterial beschichteten Zielsubstrates bearbeitet wurde.

Die erfindungsgemäße Vorrichtung sowie das erfindungsgemäße Verfahren erlauben die hochpräzise und kostengünstige Definition von Nanostrukturen auf großen Substratflächen, welche durch die aus dem Stand der Technik vorbekannten Vorrichtungen und Verfahren nicht gewährleistet werden konnte.

Durch die Nutzung einer Mehrzahl kleinerer Stempel und den Verfahrensschritt des relativen Versetzens der Stempel und des Substrats sind zwischengeschaltete Justageschritte möglich, so dass im Gegensatz zu der vorbekannten "roll-to-plate"-Technik neben einer globalen auch eine lokale Justage möglich ist. Im Gegensatz zur eingangs erwähnten "step&repeat"-Methode beschränken sich diese Justageschritte aber auf eine korrekte relative Positionierung von Stempel und Substrat aber auf eine Raumrichtung, wodurch das Verfahren deutlich vereinfacht wird.

Auch machen die erfindungsgemäße Vorrichtung und das erfindungsgemäße Verfahren die Nutzung von Stempeln möglich, deren Abmessungen klein sind gegenüber den Abmessungen des zu strukturierenden Substrats. Hierdurch entfällt die Herausforderung der Herstellung eines großflächigen Stempels sowie dessen verformungsfreier Platzierung auf einer Stempelrolle, wie sie für den "roll-to-plate"-Ansatz nötig ist.

Aufgrund der deutlich reduzierten Größe der Stempel sind die mit einem möglichen Defekt eines Stempels und dessen Austausch verbundenen Kosten deutlich geringer als im konventionellen "roll-to-plate"-Ansatz.

Schließlich können aufgrund der deutlich reduzierten Größe der Stempel die im Rahmen der vorliegenden Erfindung notwendigen Vorrichtungen wesentlich kleiner dimensioniert werden. Darüber hinaus können sie wesentlich einfacher und kostengünstiger auf neue Zielsubstratgrößen adaptiert werden.

Durch die Verwendung mehrerer Stempel auf der Rolle kann bei der Durchführung des erfindungsgemäßen Verfahrens eine entsprechende Reduzierung der Anzahl der nötigen Wiederholungen des Abwalzens der Oberfläche des zu strukturierenden Substrats möglich. Insbesondere ist bei Nutzung von hinreichend vielen auf der Mantelfläche der Stempelrolle angeordneten Stempeln nur noch eine einzige Wiederholung nötig.

Weitere bevorzugte Weiterbildungen der erfindungsgemäßen Vorrichtung zeichnen sich dadurch aus, dass die Erstreckung der einzelnen Stempel in Richtung der Rollenlängsachse nicht mehr als 51% der Erstreckung des Substrats in der Versatzrichtung beträgt, bevorzugt nicht mehr als 26% und besonders bevorzugt nicht mehr als 17%.

Weitere Vorteile lassen sich verwirklichen, wenn der Abstand der Stempel voneinander im Wesentlichen der Versatzstrecke entspricht.

In einer weiteren vorteilhaften Ausgestaltung der erfindungsgemäßen Vorrichtung sind die Seitenkanten der Stempel an der Stoßstelle, d.h. die orthogonal zur Rollrichtung der Stempelrolle orientierten Stempelsäume, bezüglich ihrer Formgebung komplementär zueinander ausgebildet sind, so dass diese Seitenkanten formschlüssig ineinander eingreifen können.

Ein Formschluss kann insbesondere in der Erstreckungsebene des einzelnen Stempels vorliegen, d.h. in der Ebene, in der sich der (noch nicht auf der Stempelrolle befestigte) Stempel erstreckt. Hierdurch kann insbesondere auf einfache Weise ein nahtloser Anschluss der an die beiden Stempelsäume angrenzenden (Nano-)Strukturen erzielt werden. Durch eine solche "selbstjustierende" Ausformung der Stempelsäume werden Versatzfehler, Stempelverzug und andere bei den bisher gebräuchlichen Ansätzen die Qualität der Strukturdefinition negativ beeinträchtigende Effekte minimiert oder vermieden.

Ein Formschluss kann aber auch in der zu dieser Ebene orthogonalen Ebene vorliegen, die gegeben ist durch die Erstreckungsrichtung der Stoßstelle und die Flächennormale der Erstreckungsebene. Insbesondere in dieser Ebene kann sich ein Formschluss in der Art eines Feder-Nut-Systems ergeben, so dass die beiden Stempelsäume ohne weitere Befestigungsmittel aneinander festgelegt und damit der Stempel in seiner Gesamtheit auf der Stempelrolle mechanisch festgelegt werden kann.

In einer weiteren vorteilhaften Ausgestaltung der erfindungsgemäßen Vorrichtung ist die von den Stempeln ausgebildete Nanostruktur in Umfangsrichtung periodisch.

In einer besonders bevorzugten Weiterbildung umfasst die erfindungsgemäße Vorrichtung weiterhin eine Mehrzahl von Justiervorrichtungen, die den Stempeln zugeordnet ist. Jedem Stempel ist eine Justiervorrichtung zugeordnet. Diese Justiervorrichtungen sind jeweils an der Stempelrolle angeordnet und erlauben eine Bewegung des zugehörigen Stempels in Bezug auf mindestens einer der folgenden Bewegungsfreiheitsgrade:
a. Rotation des Stempels in Umfangsrichtung um die Längsachse der Stempelrolle,
b. Neigung der Längsachse der vom betreffenden Stempel ausgebildeten ringförmigen Struktur gegen die Längsachse der Stempelrolle,
c. Parallelversatz der Längsachse der vom betreffenden Stempel ausgebildeten ringförmigen Struktur relativ zur Längsachse der Stempelrolle, und
d. Relativbewegung benachbarter Stempel entlang der Längsachse der Stempelrolle.

Da die erfindungsgemäße Vorrichtung mehrere Stempel umfasst, erlauben es die individuellen Justiervorrichtungen, die (Nano-)Strukturen mit hoher Präzision so relativ zueinander auszurichten, dass auch hier keinerlei Stoßkanten oder Nahtlinien in der erzeugten großformatigen (Nano-)Struktur erkennbar sind.

In einer bevorzugten Weiterbildung dieser bevorzugten Ausgestaltung der erfindungsgemäßen Vorrichtung sind die Stempel jeweils auf einem hohlzylindrischen Stempelträger angeordnet, der von der Stempelrolle getragen wird. Die jeweils einem die einem Stempel zugeordneten Justiervorrichtungen, von denen in der einfachsten Ausgestaltung nur eine vorgesehen ist, sind mechanisch zwischen Stempelrolle und dem Stempelträger angeordnet, auf dem der betreffende Stempel angeordnet ist.

Die Justiervorrichtungen erlauben es beispielsweise, die ihr jeweils zugeordneten Stempel nach dem relativen Versetzen von Stempelrolle und Substrat gezielt so zu justieren, dass die in der auf der Substratoberfläche angeordneten Schicht aus Imprintmaterial durch Stempelabformung eingebrachten Nanostrukturen nahtlos und versatzfrei aneinander angrenzen, oder bevorzugt ineinander übergehen. Auf diese Weise vereinfacht die erfindungsgemäße Vorrichtung die Erzeugung großformatiger (Nano-)Strukturen ohne sichtbare Stoßkanten oder Nahtlinien.

In einer vorteilhaften Ausgestaltung umfasst jede Justiervorrichtung eine Mehrzahl von individuell ansteuerbaren Piezoaktuatoren, die eine kontrollierte Bewegung des Stempelträgers in Bezug auf einen oder bevorzugt mehrere der o.g. Bewegungsfreiheitsgrade erlauben.

Weitere Vorteile ergeben sich, wenn die von der Vorrichtung umfassten Stempel transparent für elektromagnetische Strahlung einer bestimmten Wellenlänge ausgebildet sind. In dieser Ausgestaltung ist vorteilhaft im Inneren der von den individuellen Stempeln ausgebildeten ringförmigen Struktur eine Quelle für elektromagnetische Strahlung dieser Wellenlänge angeordnet.

Umfasst die vorstehend beschriebene Vorrichtung auch einen Stempelträger, so ergeben sich besondere Vorteile, wenn auch der Stempelträger zumindest bereichsweise transparent für die elektromagnetische Strahlung ausgebildet ist und die Quelle für elektromagnetische Strahlung im Inneren des Stempelträgers angeordnet ist.

In einer weiteren vorteilhaften Weiterbildung der erfindungsgemäßen Vorrichtung, die einen oder mehrere Stempelträger umfassen kann, aber nicht muss, ist auch die Stempelrolle zumindest bereichsweise transparent für die elektromagnetische Strahlung ausgebildet. In diesem Fall ist die Quelle für elektromagnetische Strahlung bevorzugt im Inneren der Stempelrolle angeordnet.

Vorteilhaft liegt die Wellenlänge der von der Strahlungsquelle erzeugten elektromagnetischen Strahlung im infraroten, im sichtbaren oder im ultravioletten Spektralbereich.

In einer weiteren bevorzugten Ausgestaltung umfasst die erfindungsgemäße Vorrichtung eine Übertragerrolle für das hochviskose Imprintmaterial auf die Oberfläche des Substrats. Ein solche sogenannte "Inking-Rolle" ist zum Beschichten einer Oberfläche des Substrats mit einer Nanoimprintschicht eingerichtet.

In einer bevorzugten Weiterbildung dieser Ausgestaltung der erfindungsgemäßen Vorrichtung weist die Inking-Rolle eine Justiermarke auf, die dazu ausgebildet ist, in die auf die Oberfläche des Substrats aufgebrachte Nanoimprintschicht abgeformt zu werden.

In einer weiteren bevorzugten Weiterbildung der vorgenannten Ausgestaltung der erfindungsgemäßen Vorrichtung weisen zumindest zwei Elemente der Gruppe bestehend aus Substrat, Stempel und Stempelträger oder Stempelrolle jeweils eine Justiermarke auf. In dieser Weiterbildung ergeben sich besondere Vorteile, wenn die erfindungsgemäße Vorrichtung weiterhin ein z.B. optisch arbeitendes Erfassungsmittel aufweist, welches dazu eingerichtet, anhand der zugehörigen Justiermarken die relative Lage zumindest dieser beiden Elemente zu erfassen. Bevorzugt umfasst die Vorrichtung weiterhin ein Positionierungsmittel, welches dazu eingerichtet ist, die relative Lage zumindest dieser beiden Elemente einzustellen, bevorzugt anhand der vom Erfassungsmittel erfassten relativen Lage der vorgenannten beiden Elemente.

In einer besonders bevorzugten Ausgestaltung der erfindungsgemäßen Vorrichtung bestehen die Stempel aus einem polymeren Werkstoff. Aber auch Elastomere sowie Materialien wie Polydimethylsiloxan (PDMS) oder Silikon sind grundsätzlich geeignet und haben sich in der Praxis bewährt.

Ein erfindungsgemäßes Nanoimprintverfahren ist zur Herstellung großflächiger periodischer Nanostrukturen auf einem flächenhaft ausgedehnten Substrat vorgesehen, welches bevorzugt rechteckig ausgestaltet ist. Das erfindungsgemäße Verfahren weist in seiner einfachsten Ausgestaltung die folgenden Verfahrensschritte aufweisend:
a. Bereitstellen einer erfindungsgemäßen Vorrichtung und eines Substrats und,
b. Beschichten einer Oberfläche des Substrats mit einer hochviskosen, z.B. durch Vernetzung aushärtbaren Nanoimprintschicht,
c. Abformen der Nanostrukturen des Stempels in die Nanoimprintschicht durch Abwalzen der beschichteten Oberfläche des Substrats mit der Stempelrolle in einer quer zur Längsachse der Stempelrolle verlaufenden Richtung,
d. Versetzen von Stempelrolle und Substrat relativ zueinander in Richtung der Rollenlängsachse um eine definierte Versatzstrecke,
e. Wiederholen von Schritt c., und
f. Aushärten der strukturierten Nanoimprintschicht.

Das Aushärten der Nanoimprintschicht kann beispielsweise durch strahlungsinduzierte Vernetzung eines polymeren Nanoimprintmaterials erfolgen.

Es wird darauf hingewiesen, dass das Aushärten der strukturierten Nanoimprintschicht nicht zwingend nach dem Versetzen von Stempelrolle und Substrat relativ zueinander in Richtung der Rollenlängsachse um eine definierte Versatzstrecke erfolgen muss. Vielmehr kann das Aushärten auch unmittelbar beim Abformen der Nanostrukturen des Stempels in die Nanoimprintschicht durch Abwalzen der beschichteten Oberfläche des Substrats mit der Stempelrolle erfolgen.

In einer bevorzugten Ausgestaltung des erfindungsgemäßen Verfahrens entspricht die Größe der Versatzstrecke im Wesentlichen der Erstreckung der Stempel entlang der Längsachse der Stempelrolle,

In einer weiteren bevorzugten Ausgestaltung des erfindungsgemäßen Verfahrens entspricht die Größe die Versatzstrecke im Wesentlichen dem Abstand der Stempel voneinander in Richtung der Längsachse der Stempelrolle.

In einer weiteren vorteilhaften Weiterbildung des erfindungsgemäßen Verfahrens werden die in den Verfahrensschritten c. und e. durch wiederholte Abformung der Stempel in der Nanoimprintschicht erzeugten Nanostrukturen z.B. durch geeignete Maßnahmen zur relativen Positionierung von Stempelrolle und Substrat im Raum und bezüglich des Drehwinkels der Stempelrolle in einem weiteren Verfahrensschritt aneinander ausgerichtet.

Hierzu ist weiterhin zwischen Schritt c. und Schritt e. ein Justageschritt zur Ausrichtung der in der Nanoimprintschicht erzeugten Nanostrukturen relativ zueinander vorgesehen, in dem die Stempel eine Bewegung in mindestens einer der folgenden Bewegungsfreiheitsgrade erfahren:
a. Rotation der Stempel in Umfangsrichtung um die Längsachse der Stempelrolle,
b. Neigung der Längsachse der von den betreffenden Stempeln ausgebildeten ringförmigen Strukturen gegen die Längsachse der Stempelrolle,
c. Parallelversatz der Längsachse der von den betreffenden Stempeln ausgebildeten ringförmigen Strukturen relativ zur Längsachse der Stempelrolle, und
d. Relativbewegung benachbarter Stempel entlang der Längsachse der Stempelrolle.

In einer besonders bevorzugten Ausgestaltung des erfindungsgemäßen Verfahrens umfasst die aushärtbare Nanoimprintschicht ein vernetzbares Polymer, und das Verfahren umfasst weiterhin einen Vernetzungsschritt, in dem das Polymer in der Nanoimprintschicht zumindest im Bereich der erzeugten Nanostruktur vernetzt wird.

In einer vorteilhaften Ausgestaltung des Verfahrens wird die Vernetzung mittels elektromagnetischer Strahlung initiiert. Dabei kann die Wellenlänge der elektromagnetischen Strahlung vorteilhaft im infraroten, im sichtbaren oder im ultravioletten Spektralbereich liegen.

In einer weiteren vorteilhaften Weiterbildung des erfindungsgemäßen Verfahrens erfolgt das Beschichten einer Oberfläche des Substrats mit einer Nanoimprintschicht mittels einer Inking-Rolle. Dies bedeutet, dass eine Übertragerrolle für das hochviskose Imprintmaterial vorgesehen ist, mit der dieses Material auf die Oberfläche des Substrats übertragen wird. Insbesondere kann das Imprintmaterial linienhaft entlang einer parallel zur Drehachse der Übertragerrolle verlaufenden Linie auf die Umfangsfläche der Übertragerrolle aufgebracht werden und von dieser gleichmäßig auf die Oberfläche des Substrats übertragen werden.

In einer bevorzugten Ausgestaltung von Vorrichtung und Verfahren weist die Inking-Rolle eine Justiermarke auf. Diese wird im Gang des erfindungsgemäßen Verfahrens in die auf die Oberfläche des Substrats aufgebrachte Nanoimprintschicht abgeformt.

In einer weiteren bevorzugten Ausgestaltung von Vorrichtung und Verfahren weisen zumindest zwei Elemente der Gruppe bestehend aus Substrat, Stempel und Stempelträger oder Stempelrolle jeweils eine Justiermarke auf. In dieser bevorzugten Ausgestaltung weist das Verfahren einen Ausrichtungsschritt auf, in dem die relative Lage zumindest dieser beiden Elemente erfasst und ggf. eingestellt wird.

Weitere Vorteile und Merkmale ergeben sich aus den nachfolgenden Ausführungsbeispielen, die dem Fachmann zur Veranschaulichung der vorliegenden Erfindung dienen sollen und nicht einschränkend zu verstehen sind.

Der Anmelder weist darauf hin, dass er sich das Recht vorbehält, einen separaten Schutz auch für den in der vorliegenden Anmeldung offenbarten Aufbau der Stempelrolle sowie ein darauf bezogenes Verfahren anzustreben, ohne dass diese Stempelrolle Teil einer erfindungsgemäßen Vorrichtung gemäß der vorliegenden Anmeldung oder ihre Verwendung Teil eines erfindungsgemäßen Verfahrens gemäß der vorliegenden Anmeldung sein müssen.

Die Ausführungsbeispiele werden anhand der beigefügten Zeichnung erläutert. In dieser zeigen:
- Fig. 1:: die Erzeugung eines Masters für die Stempelherstellung in schematischer Darstellung,
- Fig. 2:: das Abformen eines Stempels von dem Master gemäß Fig. 1,
- Fig. 3:: den Verfahrensgang des aus dem Stand der Technik bekannten "step&repeat"-Verfahrens in schematischer Darstellung,
- Fig. 4:: den Verfahrensgang des aus dem Stand der Technik bekannten "roll-to-plate"-Verfahrens in schematischer Darstellung,
- Fig. 5:: eine Ausführungsform einer mit einem Stempel belegten Stempelrolle,
- Fig. 6:: die Stempelrolle aus Fig. 5 mit montiertem hohlzylindrischem Stempelträger,
- Fig. 7:: die Stempelrolle aus Fig. 6 mit montierter Justiervorrichtung,
- Fig. 8:: die Justiervorrichtung aus Fig. 7 in vergrößerter Ansicht,
- Fig. 9:: die Stempelrolle aus Fig. 5 ohne Stempel, und
- Fig. 10:: den Verfahrensgang einer Ausführungsform des erfindungsgemäßen Verfahrens in schematischer Darstellung.

Figur 1 zeigt schematisch die Erzeugung eines Masters für die Stempelherstellung. Hierzu wird in der Oberfläche eines Si-Wafers mittels konventioneller Lithographieverfahren und Trockenätzen die Positivform der (Nano-)Struktur erzeugt, die mittels eines Nanoimprintverfahrens in eine Nanoimprintschicht eingebracht werden soll, die ein vernetzbares Polymer umfasst und auf einer Oberfläche eines geeigneten Substrats angeordnet ist.

Wie in Fig. 2 dargestellt werden von diesem Master ein oder mehrere Stempel abgeformt, die z.B. aus einem polymeren Werkstoff, einem Elastomer oder Materialien wie Polydimethylsiloxan (PDMS) oder Silikon bestehen können.

Hierzu wird der Master mit einer die Außenkante des späteren Stempels definierenden strukturierten Schicht, der "Maskierung", beschichtet. Die Strukturierung dieser Schicht erfolgt mittels konventioneller Lithographieverfahren und gibt den gewünschten Umriss der vom Master abgeformten Stempel vor.

Der Umriss kann dabei optional so gestaltet werden, dass beim Aufziehen des abgeformten Stempels auf eine Stempelrolle eine selbstjustierende formschlüssige Naht entsteht (nicht dargestellt). Die Ausformung des Stempelsaums orthogonal zur späteren Rollrichtung, also entlang der Längsachse der Stempelrolle, soll vorteilhaft eine selbstjustierende Montage auf die Rolle bzw. den Stempelträger ermöglichen. Dies kann durch eine formschlüssige Verbindung der beiden an diesem Saum aufeinander treffenden Stempelenden erreicht werden. Dazu werden die beiden Stempelenden so ausgeformt, dass sie zueinander inverse Strukturkanten aufweisen, welche einen stabilen und passgenauen Formschluss erlauben. Geeignete Ausformungen der Strukturkanten können dabei beispielsweise aus schwalbenschwanzartigen Strukturen bestehen, die einen sicheren, belastbaren und passgenauen Verbund der Kanten gewährleisten. Auch denkbar sind weitere Ausformungen mit ähnlichen Eigenschaften, beispielsweise reißverschlussartige Strukturkanten.

Das Aufziehen des Stempels auf eine Stempelrolle oder einen separat ausgebildeten Stempelträger, was in den Figuren nicht dargestellt ist, erfolgt bevorzugt automatisiert.

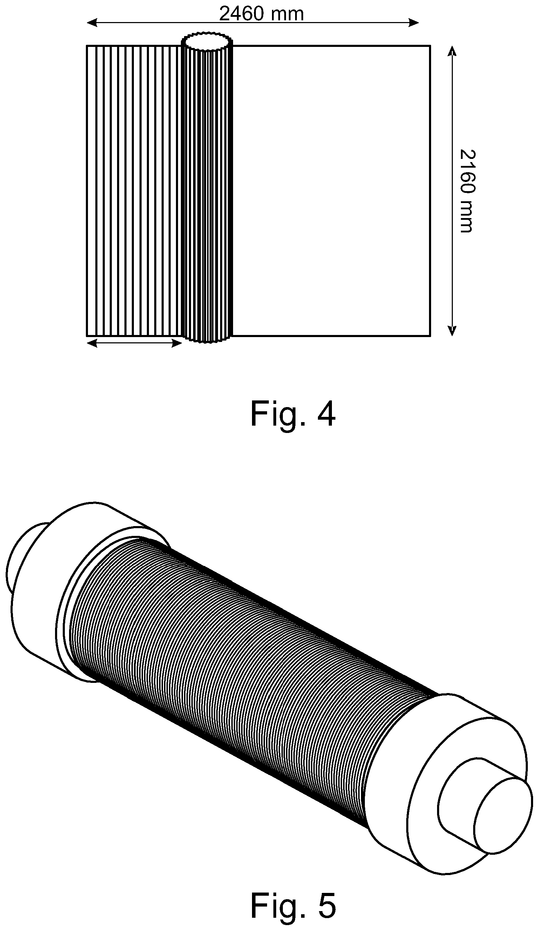

Fig. 5 zeigt eine nicht von der Erfindung erfasste Ausführungsform einer mit einem Stempel belegten Stempelrolle. Dabei umfasst die dargestellte Stempelrolle nur einen Stempel. Dieser ist auf einem Stempelträger (nicht dargestellt) angeordnet, der auf einer Justiervorrichtung montiert ist. Diese Justiervorrichtung umfasst zwei Lagerschalen und erlaubt eine Bewegung des zugehörigen Stempels in den folgenden Bewegungsfreiheitsgraden:
a. eine Rotation des Stempels in Umfangsrichtung um die Längsachse der Stempelrolle,
b. eine Neigung der Längsachse der vom betreffenden Stempel ausgebildeten ringförmigen Struktur gegen die Längsachse der Stempelrolle,
c. einen Parallelversatz der Längsachse der vom betreffenden Stempel ausgebildeten ringförmigen Struktur relativ zur Längsachse der Stempelrolle, und
d. eine Bewegung des Stempels entlang der Längsachse der Stempelrolle.

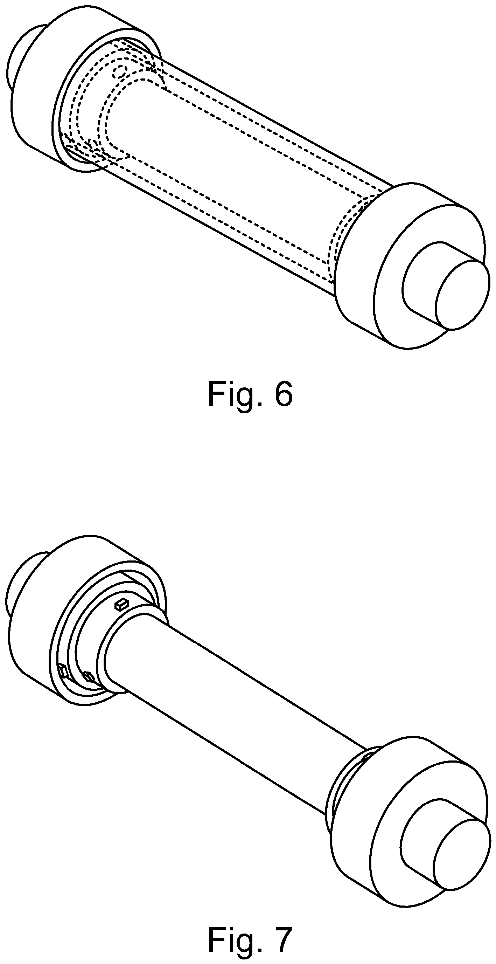

Der Stempelträger ist aus Figur 6 ersichtlich und ist in diesem Ausführungsbeispiel als dreiteiliges Bauteil ausgeführt, bestehend aus einem Hohlzylinder sowie zwei Lagerschalen, welche als Halterung für den Zylinder fungieren und die vorgenannte Justiervorrichtung ausbilden.

Der Hohlzylinder besteht dabei aus einem für die Wellenlänge der zur Aushärtung des Imprintmaterials, eines sogenannten "Imprintresists" verwendeten Lichtquelle transparenten Material, bspw. Quarzglas oder einem geeigneten Kunststoff.

Weiterhin trägt der Hohlzylinder (nicht dargestellte) Justagemarken außerhalb des vom aktiven Stempelbereich belegten Raumes, bswp. links und rechts seitlich neben diesem auf einer relativ zum aktiven Bereich tiefgestellten Fläche.

Die den Stempelträger tragenden Lagerschalen sind in den Figuren 7 und insbesondere 8 genauer dargestellt. Sie sind symmetrisch aufgebaut und beinhalten geeignete Verriegelungselemente (z.B. Rastbolzen) zur Positionierung und Fixierung der Lagerschalen auf der Stempelrolle.

Weiterhin weisen die Lagerschalen jeweils eine ringförmige Aufnahmenut für den Hohlzylinder auf. In dieser Aufnahmenut sind drei Piezoaktuatoren angeordnet, welche im Abstand von 120° angebracht sind. Diese dienen zur Feinjustage des Stempelträgers mitsamt des darauf befindlichen Polymerstempels auf der Stempelrolle und relativ zum Zielsubstrat. Die Feinjustage wird mittels eines geeigneten optischen Aufbaus (nicht dargestellt) anhand von Justagemarken durchgeführt.

Hierzu sind Zielsubstrat, Stempel und Stempelträger jeweils mit einer oder mehreren Justagemarken ausgestattet (nicht dargestellt), die eine Justage zwischen den einzelnen Elementen erlauben. Dabei können die Justagemarken seitlich neben dem eigentlichen aktiven Bereich des Stempels sowie am unteren und oberen Ende des Zielsubstrats platziert werden, so dass keine aktive Substratfläche belegt wird. Die Justage kann mittels konventioneller optischer Justagesysteme durchgeführt werden und kann insbesondere auf der Nutzung von Moire-Marken und anderen optischen Justagesystemen mit Sub-Wellenlängen-Präzision basieren. Die benötigten optischen Elemente (nicht dargestellt) können in der Stempelrolle sowie ober- oder unterhalb des Zielsubstrats platziert werden.

Die Lagerschalen umfassen weiterhin jeweils einen Metallring, welcher sich vor der jeweiligen Lagerschale befindet und drei weitere Piezoaktuatoren im Abstand von 120° trägt. Diese wirken in zentrifugaler bzw. zentripetaler Richtung ausgehend vom Ringmittelpunkt und sind somit in der Lage, den Hohlzylinder sowohl zu klemmen als auch relativ zur Rotationsachse zu verdrehen, um den Winkelfehler des Zylinders relativ zum Zielsubstrat auszugleichen.

Schließlich sind auf beiden Lagerschalen Ringschleifkontakte vorgesehen, welche zur Kontaktierung der Piezoaktuatoren dienen.

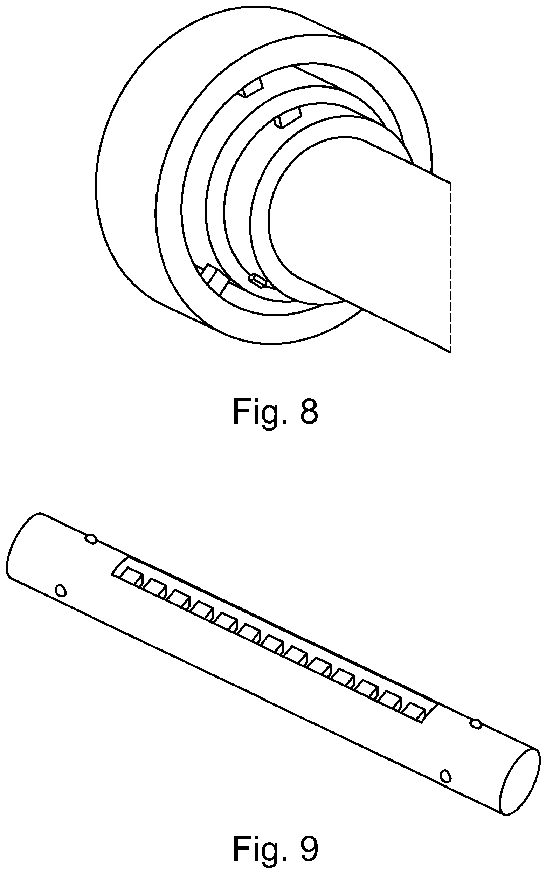

Fig. 9 zeigt schließlich die Stempelrolle aus Fig. 5 ohne darauf angeordnetem Stempel, Stempelträger sowie Justiervorrichtung. Die Stempelrolle ist in diesem Ausführungsbeispiel als transparenter Hohlzylinder ausgebildet, der beidseitig in Drehlagerungen (nicht dargestellt) gelagert ist. Er weist an seiner Mantelfläche eine Mehrzahl von Aufnahmen von Rastnuten auf, die zur Festlegung der Lagerschalen der Justiervorrichtung vorgesehen sind.

Weiterhin ist in den hohlen Innenraum der transparenten Stempelrolle ein LED-Array auf einem feststehenden Träger eingebettet, welches Licht erzeugt, das über die gesamte Länge der Stempelrolle über deren Mantelfläche ausgekoppelt wird. Die Emissionsrichtung des LED-Arrays ist im Gebrauchszustand der Stempelrolle in Richtung auf das Zielsubstrat, genauer auf die Kontaktlinie zwischen zu strukturierender Schicht aus Nanoimprintmaterial und dem darauf abrollenden Stempel gerichtet. Es durchdringt sowohl die Stempelrolle als auch den Stempelträger und den aus einem transparenten Material bestehenden Stempel und löst eine Vernetzungsreaktion in einem Polymer des Nanoimprintmaterials aus. Hierzu ist die Wellenlänge des LED-Arrays auf die Vernetzungsreaktion dieses Polymers abgestimmt.

In den hier diskutierten Ausführungsbeispielen des erfindungsgemäßen Verfahrens wird eine Oberfläche eines Zielsubstrats mit einem Imprintlack belegt, z.B. durch Nutzung einer sog. inking-Rolle (nicht dargestellt). Die inking-Rolle enthält Justagestrukturen enthalten, mit deren Hilfe die korrekte Positionierung des Zielsubstrates überprüft werden kann.

In einem ersten, nicht von der Erfindung erfassten und nicht dargestellten Ausführungsbeispiel trägt die Stempelrolle nur einen Stempel. Bei der Verwendung einer derartigen Vorrichtung werden Substrat und Stempelrolle relativ zueinander quer zur Drehachse der Stempelrolle verfahren, während der Stempel auf der Oberfläche der noch nicht ausgehärteten Imprintlackschicht abrollt und die ihm eigene (Nano-)Struktur auf die Imprintlackschicht überträgt, wobei eine erste strukturierte Bahn in der Imprintlackschicht entsteht.

Nach Durchlauf der vollen Zielsubstratlänge werden Stempelrolle und Zielsubstrat relativ zueinander in Richtung der Drehachse der Stempelrolle um eine Stempelbreite verfahren. Nachfolgend werden erneut Substrat und Stempelrolle relativ zueinander quer zur Drehachse der Stempelrolle verfahren, während der Stempel auf der Oberfläche der noch nicht ausgehärteten Imprintlackschicht abrollt und die ihm eigene (Nano-)Struktur auf die Imprintlackschicht überträgt, wobei eine zweite strukturierte Bahn in der Imprintlackschicht entsteht, die unmittelbar an die erste strukturierte Bahn angrenzt, bevorzugt dergestalt, dass die erste und die zweite Bahn eine geringe randseitige Überlappung zeigen und die jeweiligen (Nano-)Strukturen miteinander registriert sind. Dieser Vorgang wird wiederholt, bis die gesamte Fläche des Zielsubstrates bearbeitet wurde, d.h. die gesamte Oberfläche der Imprintlackschicht mit nahtlos aneinander angrenzenden Bahnen bedeckt ist.

In einer vorteilhaften Verfahrensführung wird beim Abrollen des Stempels auf der Imprintlackschicht diese lokal ausgehärtet, z.B. mittels optisch initiierter Vernetzung eines enthaltenen Polymers, so dass die eingebrachte (Nano-)Struktur fixiert wird.

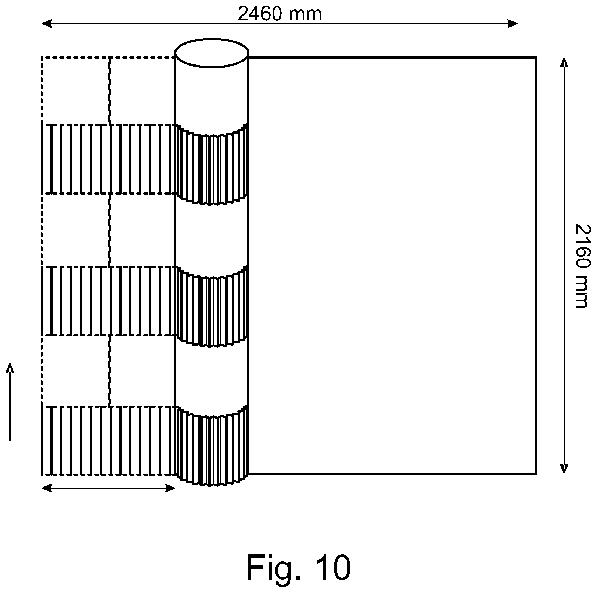

In einem weiteren , in Fig. 10 dargestellten und nunmehr erfindungsgemäßen Ausführungsbeispiel trägt die Stempelrolle mehrere identische Stempel, die jeweils im Abstand einer Stempelbreite voneinander auf der Stempelrolle angeordnet sind. Auch bei der Verwendung einer derartigen Vorrichtung werden Substrat und Stempelrolle relativ zueinander quer zur Drehachse der Stempelrolle verfahren, während die Stempel auf der Oberfläche der noch nicht ausgehärteten Imprintlackschicht abrollen und die ihnen eigene (Nano-)Strukturen auf die Imprintlackschicht übertragen, wobei eine Mehrzahl erster strukturierter Bahnen in der Imprintlackschicht entsteht.

Nach Durchlauf der vollen Zielsubstratlänge werden Stempelrolle und Zielsubstrat relativ zueinander in Richtung der Drehachse der Stempelrolle um eine Stempelbreite verfahren. Nachfolgend werden erneut Substrat und Stempelrolle relativ zueinander quer zur Drehachse der Stempelrolle verfahren, während die Stempel auf der Oberfläche der noch nicht ausgehärteten Imprintlackschicht abrollen und die ihnen eigenen (Nano-)Strukturen auf die Imprintlackschicht übertragen, wobei eine Mehrzahl zweiter strukturierter Bahnen in der Imprintlackschicht entsteht, die unmittelbar an die ersten strukturierten Bahnen angrenzen und den Zwischenraum zwischen diesen vollständig ausfüllen.

Dieser Vorgang muss nur einmal ausgeführt werden, da bereits die gesamte Fläche des Zielsubstrates bearbeitet wurde, d.h. die gesamte Oberfläche der Imprintlackschicht mit nahtlos aneinander angrenzenden Bahnen bedeckt ist.

Auch in diesem erfindungsgemäßen Ausführungsbeispiel hat es sich als vorteilhaft erwiesen, wenn die ersten und die zweiten Bahnen jeweils eine geringe randseitige Überlappung zeigen und die jeweiligen (Nano-)Strukturen miteinander registriert sind.

## Patentansprüche

1. Vorrichtung zur Herstellung großflächiger periodischer Nanostrukturen auf einem flächenhaft ausgedehnten, bevorzugt rechteckigen Substrat, mittels eines Nanoimprintverfahrens, die folgenden Merkmale aufweisend:
a. eine Stempelrolle mit einer Längsachse, an deren Umfangsfläche eine Mehrzahl von gleichartigen Stempeln angeordnet ist, wobei
i. jeder dieser Stempel in Umfangsrichtung der Stempelrolle
1. eine ringförmige Struktur und
2. eine Nanostruktur ausbildet, die ein Negativ zumindest zu einem Teilbereich der herzustellenden Nanostruktur darstellt,
ii. die Stempel in Richtung der Rollenlängsachse beabstandet voneinander angeordnet sind, und
iii. der Abstand der Stempel voneinander kleiner oder gleich der Erstreckung der Stempel in Richtung der Rollenlängsachse ist,
b. eine Versatzvorrichtung, mittels welcher Stempelrolle und Substrat in Richtung der Rollenlängsachse relativ zueinander um eine definierte Versatzstrecke versetzt werden können.

2. Vorrichtung gemäß Anspruch 1, **dadurch gekennzeichnet, dass** die Erstreckung der Stempel in Richtung der Rollenlängsachse nicht mehr als 51% der Erstreckung des Substrats in die Versatzrichtung beträgt, bevorzugt nicht mehr als 26% und besonders bevorzugt nicht mehr als 17%.

3. Vorrichtung gemäß Anspruch 1, **dadurch gekennzeichnet, dass** der Abstand der Stempel voneinander im Wesentlichen der Versatzstrecke entspricht.

4. Vorrichtung gemäß Anspruch 1, **dadurch gekennzeichnet, dass** die Seitenkanten der Stempel an der Stoßstelle komplementär zueinander ausgebildet sind, so dass die Seitenkanten formschlüssig ineinander eingreifen können.

5. Vorrichtung gemäß Anspruch 1, **dadurch gekennzeichnet, dass** die von den Stempeln ausgebildete Nanostruktur in Umfangsrichtung periodisch ist.

6. Vorrichtung gemäß Anspruch 1, **dadurch gekennzeichnet, dass**
a. die Stempel transparent für elektromagnetische Strahlung einer bestimmten Wellenlänge ausgebildet sind, und
b. im Inneren der von den Stempeln ausgebildeten ringförmigen Strukturen eine Quelle für elektromagnetische Strahlung dieser Wellenlänge angeordnet ist.

7. Vorrichtung gemäß Anspruch 6, **dadurch gekennzeichnet, dass** die Wellenlänge der elektromagnetischen Strahlung im infraroten, im sichtbaren oder im ultravioletten Spektralbereich liegt.

8. Vorrichtung gemäß Anspruch 1, **dadurch gekennzeichnet, dass** die Vorrichtung eine Inking-Rolle umfasst, die zum Beschichten einer Oberfläche des Substrats mit einer Nanoimprintschicht eingerichtet ist.

9. Vorrichtung gemäß Anspruch 8, **dadurch gekennzeichnet, dass** die Inking-Rolle eine Justiermarke aufweist, die dazu ausgebildet ist, in die auf die Oberfläche des Substrats aufgebrachte Nanoimprintschicht abgeformt zu werden.

10. Nanoimprintverfahren zur Herstellung großflächiger periodischer Nanostrukturen auf einem flächenhaft ausgedehnten, bevorzugt rechteckigen Substrat, die folgenden Verfahrensschritte aufweisend:
a. Bereitstellen eines Substrats,
b. Bereitstellen einer Vorrichtung gemäß Anspruch 1,
c. Beschichten einer Oberfläche des Substrats mit einer Nanoimprintschicht, die ein vernetzbares Polymer umfasst,
d. Abformen der Nanostrukturen des Stempels in die Nanoimprintschicht durch Abwalzen der beschichteten Oberfläche des Substrats mit der Stempelrolle in einer quer zur Längsachse der Stempelrolle verlaufenden Richtung,
e. Versetzen von Stempelrolle und Substrat relativ zueinander in Richtung der Rollenlängsachse um eine definierte Versatzstrecke,
f. Wiederholen von Schritt d., und
g. Vernetzen des Polymers.

11. Verfahren gemäß Anspruch 10, **dadurch gekennzeichnet, dass** die Versatzstrecke im Wesentlichen dem Abstand der Stempel voneinander in Richtung der Längsachse der Stempelrolle entspricht

12. Verfahren gemäß Anspruch 10, **dadurch gekennzeichnet, dass** das Verfahren weiterhin einen Vernetzungsschritt umfasst, in dem das Polymer in der Nanoimprintschicht im Bereich der erzeugten Nanostruktur vernetzt wird.

13. Verfahren gemäß Anspruch 12, **dadurch gekennzeichnet, dass** die Vernetzung mittels elektromagnetischer Strahlung initiiert wird.

14. Verfahren gemäß Anspruch 13, **dadurch gekennzeichnet, dass** die Wellenlänge der elektromagnetischen Strahlung im infraroten, im sichtbaren oder im ultravioletten Spektralbereich liegt.

## Claims

1. Device for the production of large-area periodic nanostructures on an areally-extended, preferably rectangular, substrate, by means of a nano-imprint method, having the following features:
a. a stamp roller with a longitudinal axis, on the circumferential surface of which a number of stamps of the same type are arranged, wherein
i. in the circumferential direction of the stamp roller each of these stamps forms:
1. an annular structure, and
2. a nanostructure, which represents a negative of at least a partial region of the nanostructure to be produced,
ii. the stamps are spaced apart from each other in the direction of the longitudinal axis of the roller, and
iii. the distance between the stamps is less than or equal to the extent of the stamps in the direction of the longitudinal axis of the roller,
b. an offset device, by means of which the stamp roller and substrate can be offset relative to each other in the direction of the longitudinal axis of the roller by a defined offset distance.

2. Device according to Claim 1,
**characterised in that**,
the extent of the stamps in the direction of the longitudinal roller axis is not more than 51 % of the extent of the substrate in the offset direction, preferably not more than 26 %, and particularly preferably not more than 17 %.

3. Device according to Claim 1,
**characterised in that**,
the distance between the stamps essentially corresponds to the offset distance.

4. Device according to Claim 1,
**characterised in that**,
the side edges of the stamps are designed to be complementary to each other at the butt joint, so that the side edges can engage with each other in a form fit.

5. Device according to Claim 1,
**characterised in that**,
the nanostructure formed by the stamps is periodic in the circumferential direction.

6. Device according to Claim 1,
**characterised in that**,
a. the stamps are designed to be transparent to electromagnetic radiation at a certain wavelength, and
b. a source of electromagnetic radiation at this wavelength is arranged in the interior of the annular structures formed by the stamps.

7. Device according to Claim 6,
**characterised in that**,
the wavelength of the electromagnetic radiation lies in the infrared, visible, or ultraviolet spectral range.

8. Device according to Claim 1,
**characterised in that**,
the device comprises an inking roller, which is equipped to coat a surface of the substrate with a nano-imprint layer.

9. Device according to Claim 8,
**characterised in that**,
the inking roller has an alignment mark, which is designed to be moulded into the nano-imprint layer applied to the surface of the substrate.

10. Nanoimprint method for the production of large-area periodic nanostructures on an areally-extended, preferably rectangular, substrate, comprising the following method steps:
a. Provision of a substrate,
b. Provision of a device according to Claim 1,
c. Coating of a surface of the substrate with a nano-imprint layer, which comprises a cross-linkable polymer,
d. Moulding of the nanostructures of the stamp into the nano-imprint layer by rolling the coated surface of the substrate with the stamp roller in a direction transverse to the longitudinal axis of the stamp roller,
e. Offsetting of the stamp roller and substrate relative to each other, in the direction of the longitudinal axis of the roller, by a defined offset distance,
f. Repetition of step d, and
g. Cross-linking of the polymer.

11. Method according to Claim 10,
**characterised in that**,
the offset distance essentially corresponds to the distance between the stamps in the direction of the longitudinal axis of the stamp roller.

12. Method according to Claim 10,
**characterised in that**,
the method further comprises a cross-linking step, in which the polymer in the nano-imprint layer is cross-linked in the region of the generated nanostructure.

13. Method according to Claim 12,
**characterised in that**,
the cross-linking is initiated by means of electromagnetic radiation.

14. Method according to Claim 13,
**characterised in that**,
the wavelength of the electromagnetic radiation lies in the infrared, visible, or ultraviolet spectral range.

## Revendications

1. Dispositif de fabrication de nanostructures périodiques de grande surface sur un substrat expansé en surface, de préférence rectangulaire au moyen d'un procédé de nanoimpression, comportant les caractéristiques suivantes :
a. un rouleau d'empreintes avec un axe longitudinal à la surface périphérique duquel est disposée une pluralité d'empreintes identiques, sachant que
i. chacune de ces empreintes constitue en direction périphérique du rouleau d'empreintes
1. une structure annulaire et
2. une nanostructure, qui présente un négatif au moins pour une partie de zone de la nanostructure à réaliser,
ii. les empreintes sont disposées entre elles à distance en direction de l'axe longitudinal de rouleau et
iii. la distance des empreintes entre elles est plus petite ou identique à l'extension des empreintes en direction de l'axe longitudinal de rouleau
b. un dispositif de décalage au moyen duquel le rouleau d'empreinte et le substrat peuvent être décalés l'un par rapport à l'autre d'une distance de décalage définie en direction de l'axe longitudinal de rouleau.

2. Dispositif selon la revendication 1, **caractérisé en ce que** l'extension des empreintes en direction de l'axe longitudinal de rouleau n'est pas supérieure à 51 % de l'extension du substrat dans la direction de décalage, de préférence pas supérieure à 26 % et en particulier de préférence pas supérieure à 17 %.

3. Dispositif selon la revendication 1, **caractérisé en ce que** la distance des empreintes entre elles correspond pour l'essentiel à la distance de décalage.

4. Dispositif selon la revendication 1, **caractérisé en ce que** les bords latéraux des empreintes au point de contact sont constitués de façon complémentaire les uns par rapport aux autres, de telle manière que les bords latéraux peuvent venir en prise les uns dans les autres par conformité de forme.

5. Dispositif selon la revendication 1, **caractérisé en ce que** la nanostructure constituée par les empreintes est périodique en direction périphérique.

6. Dispositif selon la revendication 1, **caractérisé en ce que**
a. les empreintes sont constituées transparentes pour le rayonnement électromagnétique d'une longueur d'ondes déterminée et
b. une source pour le rayonnement électromagnétique de cette longueur d'ondes est disposée à l'intérieur des structures annulaires constituées par les empreintes.

7. Dispositif selon la revendication 6, **caractérisé en ce que** la longueur d'ondes du rayonnement électromagnétique se situe dans une zone spectrale infrarouge, visible ou ultraviolette.

8. Dispositif selon la revendication 1, **caractérisé en ce que** le dispositif comprend un rouleau encreur, qui est agencé pour revêtir une surface du substrat avec une couche de nanoimpression.

9. Dispositif selon la revendication 8, **caractérisé en ce que** le rouleau encreur comporte un repère de réglage, qui est constitué pour être déformé dans la couche de nanoimpression appliquée à la surface du substrat.

10. Procédé de nanoimpression pour la fabrication de nanostructures périodiques de grande surface sur un substrat expansé en surface, de préférence rectangulaire, comportant les étapes de procédé suivantes :
a. préparation d'un substrat,
b. Préparation d'un dispositif selon la revendication 1,
c. revêtement d'une surface du substrat avec une couche de nanoimpression, qui comprend un polymère réticulable
d. modelage des nanostructures de l'empreinte dans la couche de nanoimpression en aplanissant au rouleau la surface revêtue du substrat avec le rouleau d'empreintes dans une direction passant transversalement à l'axe longitudinal du rouleau d'empreinte,
e. déport d'une distance de décalage définie du rouleau d'empreintes et du substrat l'un par rapport à l'autre en direction de l'axe longitudinal de rouleau,
f. répétition de l'étape d et
g. réticulation du polymère.

11. Procédé selon la revendication 10, **caractérisé en ce que** la distance de déport correspond pour l'essentiel à la distance des empreintes entre elles en direction de l'axe longitudinal du rouleau d'empreintes.

12. Procédé selon la revendication 10, **caractérisé en ce que** le procédé comprend en plus une étape de réticulation dans laquelle le polymère est réticulée dans la couche de nanoimpression dans la zone de la nanostructure produite.

13. Procédé selon la revendication 12, **caractérisé en ce que** la réticulation est initiée au moyen d'un rayonnement électromagnétique.

14. Procédé selon la revendication 13, **caractérisé en ce que** la longueur d'ondes du rayonnement électromagnétique se situe dans une zone spectrale infrarouge, visible ou ultraviolette.
